# EUROPEAN PATENT APPLICATION

(11) **EP 4 534 339 A1**
(43) Date of publication of application: **09.04.2025**
(21) Application number: 23814992.6
(22) Date of filing: 19.05.2023
(51) Int. Cl.: B60L 58/12

(54) **BATTERY CELL MANAGEMENT CHIP, AND BATTERY SYSTEM AND VEHICLE**

(30) Priority: 30.05.2022 CN 202210602286
(71) Applicant: BYD Company Limited, Shenzhen, Guangdong 518118 (CN)
(72) Inventor: BAO, Wenjing, Shenzhen, Guangdong 518118 (CN); LI, Jie, Shenzhen, Guangdong 518118 (CN); LI, Qifeng, Shenzhen, Guangdong 518118 (CN); YANG, Yun, Shenzhen, Guangdong 518118 (CN)
(74) Representative: Mathys & Squire
(86) International application number: PCT/CN2023/095296
(87) International publication number: WO 2023/231808

(57) **Abstract**

A vehicle (3000), having a battery system (2000), and the battery system (2000) having a battery cell management chip (10), wherein the chip (10) comprises a collection circuit (102), a power source (103), a processing circuit (101), and a dynamic protection circuit (106); the collection circuit (102) is used for collecting a parameter value of a working parameter of a single battery cell (2001) and transmitting the parameter value to the processing circuit (101); the power source (103) supplies power to the processing circuit (101); a storage circuit (105) is used for storing a dynamic protection threshold value for the working parameter; the processing circuit (101) is used for adjusting the working state of the single battery cell (2001) in the case of an anomaly; and the dynamic protection circuit (106) is used for adjusting the working state of the single battery cell (2001) according to the dynamic protection threshold value.

## Description

### CROSS-REFERENCE TO RELATED APPLICATIONS

The present disclosure claims priority to Chinese Patent Application No. 202210602286.5 entitled "BATTERY CELL MANAGEMENT CHIP, AND BATTERY SYSTEM, AND VEHICLE" filed on May 30, 2022, which is incorporated herein by reference in its entirety.

### FIELD

The present disclosure relates to the field of power batteries, and in particular to a battery cell management chip, a battery system, and a vehicle.

### BACKGROUND

In a conventional battery management system (BMS), the information detection is mainly performed on single battery, and the voltage and temperature acquisition is mainly performed on battery modules (i.e. multiple battery cells), rather than monitoring the status of a single battery cell. Furthermore, acquiring the state of charge of the battery mainly relies on the detection system acquiring measurement parameters such as voltage, current and temperature of the battery module at different periods, and the relevant parameters of single battery cell cannot be acquired. Therefore, there is a certain degree of error in the acquired state of charge of the battery. In addition, the operating state of the battery cannot be adjusted according to the usage state of the single battery cell, thus the effective usage rate of the battery is affected.

### SUMMARY

In view of the above problems, embodiments of the present disclosure are presented in order to provide a battery cell management chip, a battery system, and a vehicle that overcome or at least partially address the above problems.

According to an embodiment of the first aspect of the present disclosure, a battery cell management chip is connected to a single battery cell. The battery cell management chip includes: a processing circuit; an acquisition circuit connected to the processing circuit and configured to acquire a parameter value of an operating parameter of the single battery cell and transmit the parameter value to the processing circuit; a power supply connected to the processing circuit and configured to supply power to the processing circuit; a dynamic protection circuit connected to the processing circuit; and a storage circuit connected to the processing circuit and configured to store a dynamic protection threshold for the operating parameter. The processing circuit is configured to compare the parameter value of the operating parameter with the dynamic protection threshold and control the dynamic protection circuit to adjust the operating state of the single battery cell according to the comparison result, and determine a state of charge (SOC) of the single battery cell according to the parameter value of the operating parameter and update the dynamic protection threshold of the single battery cell stored in the storage circuit according to the SOC; and the dynamic protection circuit is configured to adjust the operating state of the single battery cell according to the dynamic protection threshold.

According to some embodiments of the present disclosure, the operating parameter includes stress, and the acquisition circuit includes a stress acquisition circuit configured to acquire a stress value of the single battery cell.

According to some embodiments of the present disclosure, the dynamic protection circuit includes a state protection circuit configured to control the single battery cell to stop charging or discharging when the stress value of the single battery cell is greater than a dynamic stress protection threshold.

According to some embodiments of the present disclosure, the stress acquisition circuit includes a bridge circuit connected to the single battery cell via an external sensor, and the bridge circuit is configured to determine a strain voltage signal according to strain information inside the single battery cell detected by the external sensor.

According to some embodiments of the present disclosure, the external sensor is a stress sensor, and the stress sensor is a thin film strain gauge.

According to some embodiments of the present disclosure, the thin film strain gauge is provided on a housing of the single battery cell.

According to some embodiments of the present disclosure, the stress acquisition circuit further includes: an amplifying circuit connected to the bridge circuit and configured to amplify the strain voltage signal; a signal acquisition circuit connected to the amplifying circuit and configured to acquire the strain voltage signal outputted by the amplifying circuit and convert the strain voltage signal into a digital signal form; a digital logic circuit connected to the signal acquisition circuit and configured to optimize and adjust the strain voltage signal in the digital signal form; and a communication interface connected to the digital logic circuit and configured to transmit the strain voltage signal in the digital signal form to the processing circuit.

According to some embodiments of the present disclosure, the signal acquisition circuit is further configured to acquire the strain voltage signal outputted by the amplifying circuit and convert the strain voltage signal into the digital signal form after being woken up. The stress acquisition circuit further includes: a wake-up reference circuit connected to the digital logic circuit and configured to store a stress threshold in an analog signal form and update the stress threshold in the analog signal form according to the strain voltage signal in the digital signal form sent by the digital logic circuit; and an acquisition wake-up circuit connected to each of the amplifying circuit, the wake-up reference circuit, and the signal acquisition circuit and configured to compare the amplified strain voltage signal with the stress threshold in the analog signal form, awaken the signal acquisition circuit when the amplified strain voltage signal exceeds the stress threshold in the analog signal form, and disconnect the signal acquisition circuit after the acquisition is completed.

According to some embodiments of the present disclosure, the processing circuit is further configured to set the stress threshold initially stored in the wake-up reference circuit.

According to some embodiments of the present disclosure, the battery cell management chip further includes a wireless transmission circuit connected to the processing circuit, the wireless transmission circuit is configured to perform wireless data transmission with an upper level control circuit, and the battery cell management chip communicates with the upper level control circuit via the wireless transmission circuit.

According to some embodiments of the present disclosure, the wireless transmission circuit is further configured to switch different operating states according to signals sent by the processing circuit, and the different operating states include a sleep state, an unsleep state, a synchronous transceiving mode and a low power consumption mode.

According to some embodiments of the present disclosure, the processing circuit includes a calculation circuit configured to calculate the state of charge SOC of the single battery cell according to the parameter value of the operating parameter, determine the new dynamic protection threshold according to the SOC, and store the new dynamic protection threshold in the storage circuit.

According to some embodiments of the present disclosure, the processing circuit further includes an alarming circuit configured to compare the parameter value of the operating parameter with the dynamic protection threshold for the operating parameter stored in the storage circuit and send an alarming message to the upper level control circuit according to the comparison result.

According to some embodiments of the present disclosure, the processing circuit further includes a control circuit configured to control the dynamic protection circuit to adjust the operating states of the single battery cell according to the alarming message.

According to some embodiments of the present disclosure, the operating parameters further include at least one of a voltage, a current, a temperature, and the acquisition circuit includes at least one of a voltage acquisition circuit, a current acquisition circuit and a temperature acquisition circuit. The voltage acquisition circuit is configured to acquire the voltage value of the single battery cell, the current acquisition circuit is configured to acquire the current value of the single battery cell and the temperature acquisition circuit is configured to acquire the temperature value of the single battery cell.

According to some embodiments of the present disclosure, the acquisition circuit includes a multiplexer, one end of the multiplexer is connected to each of the voltage acquisition circuit, the current acquisition circuit, the temperature acquisition circuit and the stress acquisition circuit, and the other end of the multiplexer is connected to the processing circuit. The processing circuit is further configured to send a selection instruction to the multiplexer. The multiplexer is configured to select any one of the voltage acquisition circuit, the current acquisition circuit, the temperature acquisition circuit and the stress acquisition circuit according to the selection instruction to transmit the parameter value of the operating parameter of the single battery cell to the processing circuit.

According to some embodiments of the disclosure, the dynamic protection circuit includes an over-voltage protection circuit configured to control the single battery cell to stop charging or discharging when the voltage value of the single battery cell exceeds a dynamic voltage protection threshold.

According to some embodiments of the present disclosure, the dynamic protection circuit further includes at least one of an equalization circuit, an over-temperature protection circuit, and an over-current protection circuit. The equalization circuit is configured to initiate a voltage equalization strategy when the voltage value of the single battery cell lies outside a preset average voltage value interval such that the voltage value of the single battery cell lies within the preset average voltage value interval. The over-temperature protection circuit is configured to control the single battery cell to enter a sleep state when the temperature value of the single battery cell exceeds a dynamic temperature protection threshold. The over-current protection circuit is configured to control the single battery cell to stop charging or discharging when the current value of the single battery cell exceeds a dynamic current protection threshold.

According to an embodiment of the second aspect of the present disclosure, a battery system includes: a plurality of single battery cells; a battery cell management system; and the battery cell management chip according to any embodiment of the first aspect of the disclosure described above.

According to an embodiment of the third aspect of the present disclosure, a vehicle includes the battery system according to any embodiment of the second aspect of the present disclosure above.

Embodiments of the present disclosure include the following advantages: the acquisition circuit is configured to acquire the parameter value of the operating parameter of the single battery cell and transmit the parameter value to the processing circuit; the power supply is configured to supply power to the processing circuit; the storage circuit is configured to store the dynamic protection threshold for the operating parameter; the processing circuit is configured to compare the parameter value of the operating parameter to the dynamic protection threshold, control the dynamic protection circuit to adjust the operating state of the single battery cell according to the comparison result, and determine the state of charge (SOC) of the single battery cell according to the parameter value of the operating parameter and update the dynamic protection threshold of the single battery cell stored in the storage circuit according to the SOC; and dynamic protection circuit is configured to adjust the operational state of the single battery cell according to the dynamic protection threshold. In the present disclosure, the state of a single battery cell is monitored by a battery cell management chip, the risk of losing state information of multiple battery strings due to the failure of a single battery cell is reduced, the dynamic protection circuit adjusts the operating state of the battery cell according to the usage state of the battery cell in real time, the high-efficiency use and protection of the battery can be achieved, and the battery life can be extended.

### BRIEF DESCRIPTION OF THE DRAWINGS

FIG. 1 is a block diagram of a battery cell management chip according to an embodiment of the present disclosure;
FIG. 2 is a circuit block diagram of a stress acquisition circuit according to an embodiment of the present disclosure;
FIG. 3 is a block diagram of a processing circuit according to an embodiment of the present disclosure;
FIG. 4 is a block diagram of a battery system according to an embodiment of the present disclosure;
FIG. 5 is a block diagram of a vehicle according to an embodiment of the present disclosure.

### Description of Reference Numerals:

10- battery cell management chip, 20-upper level control circuit;
101-processing circuit, 1011- calculation circuit, 1012-alarming circuit, 1013-control circuit;
102-acquisition circuit, 1021-voltage acquisition circuit, 1022- current acquisition circuit, 1023-temperature acquisition circuit, 1024-stress acquisition circuit, 1025- multiplexer;
10241-external sensor, 10242-bridge circuit, 10243-amplifying circuit, 10244-acquisition wake-up circuit, 10245-wake-up reference circuit, 10246-signal acquisition circuit, 10247-digital logic circuit, 10248-communication interface;
103-power supply; 104-wireless transmission circuit; 105-storage circuit;
106-dynamic protection circuit, 1061-equalization circuit, 1062-over-voltage protection circuit, 1063-over-temperature protection circuit, 1064-over-current protection circuit, 1065-state protection circuit.

### DETAILED DESCRIPTION

In order to make the above objectives, features, and advantages of the present disclosure more obvious and understandable, the present disclosure are described below in detail with reference to the accompanying drawings and detailed description.

In a conventional BMS, typically a battery module is formed from a plurality of single battery cells, and a plurality of battery modules are configured to form a battery for power supply. At present, BMS mainly monitors the information of a single battery, and mainly detects the voltage and temperature of battery modules, without monitoring the parameters of single battery cells. Therefore, when a single battery cell fails and causes the entire battery to fail, it is not easy to detect the failed single battery cell. When the battery is in different usage states, the operating state of the battery cannot be dynamically adjusted to operate within a safety threshold, thereby shortening the service life of the battery.

Based on this, one of the core concepts of embodiments of the present disclosure is to provide a wireless management chip for the single battery cell. The state of charge of a single battery cell is monitored by a wireless management chip and the operating state of the single battery cell is adjusted in real time according to different states of charge of the single battery cell, thereby realizing the efficient use of the battery and the protection of the battery.

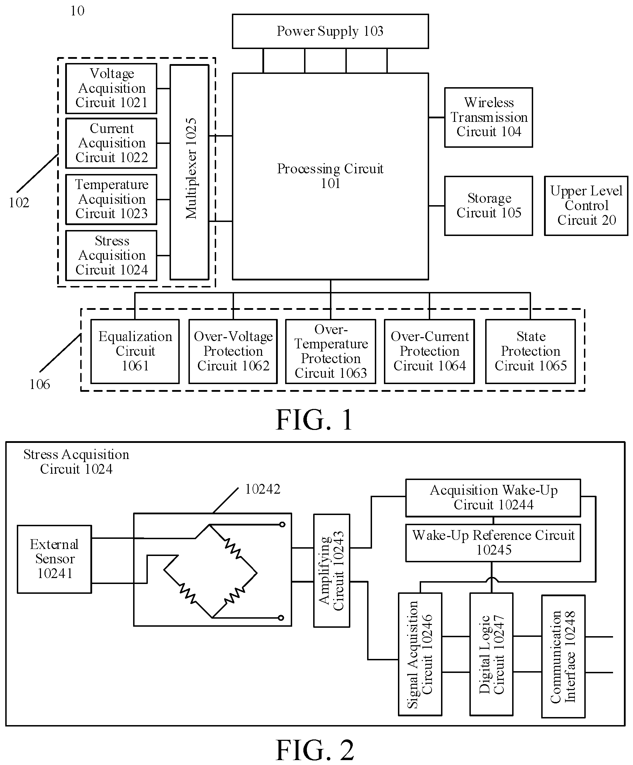

FIG. 1 shows a block diagram of a wireless management chip according to an embodiment of the first aspect of the present disclosure. The wireless management chip is a battery cell management chip 10. The battery cell management chip 10 is connected to a single battery cell, and the battery cell management chip 10 includes a processing circuit 101, an acquisition circuit 102 connected to the processing circuit 101, a power supply 103, a storage circuit 105, and a dynamic protection circuit 106.

Note that, the battery cell management chip 10 may be located inside the single battery cell, for example, a portion or an entirety of the battery cell management chip 10 is located inside the single battery cell, or the battery cell management chip 10 may be located outside of the single battery cell. When the battery cell management chip 10 is located inside the single battery cell, due to the presence of the electrolyte inside the single battery cell, it is necessary to ensure the sealing of the battery cell management chip 10 to prevent the electrolyte from infiltrating into the interior of the battery cell management chip 10, thereby avoiding damage to the components.

The acquisition circuit 102 is configured to acquire a parameter value of an operating parameter of the single battery cell and transmit the parameter value to the processing circuit 101.

In an embodiment of the present disclosure, the operating parameter refers to an output parameter that is representative of the operating state of the single battery cell. For example, the output parameter may be at least one of a voltage, a current, a temperature and a stress.

The power supply 103 is configured to supply power to the processing circuit 101, and the storage circuit 105 is configured to store a dynamic protection threshold for the operating parameter.

In an embodiment of the present disclosure, the dynamic protection threshold refers to the protection threshold corresponding to the operating parameter that ensures the normal operation of the single battery cell. For example, the dynamic voltage protection threshold refers to the protection threshold of the output voltage that ensures the normal operation of the single battery cell. The dynamic protection threshold may be set by the upper level control circuit or the processing circuit 101 according to the initial state of charge of the single battery cell when the single battery cell is initially used.

The processing circuit 101 is configured to compare the parameter value of the operating parameter with the dynamic protection threshold, and control the dynamic protection circuit 106 to adjust the operating state of the single battery cell according to the comparison result. The operating states of the single battery cell may include a discharging state, a charging state, and a sleep state. The processing circuit 101 may determine whether the parameter value of the single battery cell is normal according to the comparison result. When the parameter value of the operating parameter exceeds the dynamic protection threshold, it indicates that the single battery cell is operating abnormally.

In one embodiment, when the single battery cell is in a charging state, if the parameter value of the current parameter exceeds the dynamic current protection threshold, it indicates that the single battery cell is operating abnormally. At this point, the processing circuit 101 may control the dynamic protection circuit 106 to stop charging the single battery cell or to control the single battery cell to enter the discharging state or enter the sleep state.

In another embodiment, when the single battery cell is in a discharging state, if the parameter value of the voltage parameter exceeds the dynamic voltage protection threshold, it indicates that the single battery cell is operating abnormally. At this point, the processing circuit 101 may control the dynamic protection circuit 106 to make the single battery cell into the sleep state.

In an embodiment, the processing circuit 101 determines the state of charge SOC of the single battery cell according to the parameter value of the operating parameter and updates the dynamic protection threshold of the single battery cell stored in the storage circuit 105 according to the SOC.

In an embodiment of the present disclosure, the processing circuit 101 can compare the parameter value acquired by the acquisition circuit 102 with the dynamic protection threshold stored in the storage circuit 105 to determine whether the single battery cell is operating abnormally. Abnormal means that the parameter value of the single battery cell exceeds the dynamic protection threshold. If the abnormal state of a single battery cell lasts for too long, it may affect the operating performance of the single battery cell or cause permanent damage to the single battery cell. Due to the continuous weakening of the state of charge of a single battery cell over a long period of charging and discharging, the parameter values such as voltage, current, temperature, and stress will also constantly change. Therefore, it is necessary to continuously update the dynamic protection threshold based on the SOC calculated by the processing circuit 101 at different times according to the operating state of the single battery cell, thereby achieving more accurate protection and high-performance use.

The dynamic protection circuit 106 is configured to adjust the operating state of the single battery cell according to the dynamic protection threshold.

The dynamic protection circuit 106 can adjust state of the single battery cell in real time according to the usage state of the battery, so that the single battery cell can operate within dynamic protection threshold, thereby achieving more intelligent and accurate protection of the single battery cell.

In an embodiment of the present disclosure, the state of a single battery cell is monitored by a battery cell management chip 10, and the risk of losing state information of multiple battery strings due to the failure of a single battery cell is reduced. The dynamic protection circuit 106 adjusts the operating state of the single battery cell according to the usage state of the single battery cell in real time, the high-efficiency use and protection of the battery can be achieved, and the battery life can be extended.

In an embodiment of the present disclosure, the operating parameter includes stress and the acquisition circuit 102 includes a stress acquisition circuit.

The stress acquisition circuit is configured to acquire a stress value of the single battery cell. For example, the acquisition circuit 102 in FIG. 1 may include only the stress acquisition circuit 1024.

Gas is generated during the reaction of the electrolyte inside the single battery cell such that the stress inside the single battery cell differs at different times. The stress changes inside the single battery cell can be acquired by a stress sensor provided on the housing of the single battery cell in the stress acquisition circuit 1024.

In an embodiment of the disclosure, the dynamic protection circuit 106 includes a state protection circuit. For example, the dynamic protection circuit 106 in FIG. 1 may include only the state protection circuit 1065.

The state protection circuit 1065 is configured to control the single battery cell to stop charging or discharging when the stress value of the single battery cell is greater than a dynamic stress protection threshold.

Normally, the stress withstood by each single battery cell has a certain threshold, and the dynamic stress protection threshold is the maximum stress that a single battery cell can withstand. When the stress withstood by the single battery cell exceeds the dynamic stress protection threshold, it indicates an internal overvoltage in the battery cell. At this point, on the one hand, an alarming circuit 1012 sends an alarm to the upper level control circuit, and on the other hand, the state protection circuit 1065 controls the single battery cell to stop charging or discharging, i.e. enter a sleep state.

FIG. 2 illustrates a circuit block diagram of a stress acquisition circuit 1024 in an embodiment of the present disclosure. In an embodiment of the present disclosure, the stress acquisition circuit 1024 may include a bridge circuit 10242. The bridge circuit 10242 is connected to the single battery cell via an external sensor 10241, and the bridge circuit 10242 is configured to determine a strain voltage signal according to strain information of the single battery cell detected by the external sensor 10241.

In general, the resistance signal detected by the external sensor 10241 is very weak, and a specialized circuit must be configured to measure this weak signal. The bridge circuit 10242 used in the embodiment of the present disclosure generates a strain voltage signal after receiving the resistance signal.

In one embodiment of the present disclosure, the external sensor 10241 is a stress sensor that is a thin film strain gauge.

The external sensor 10241 can be provided on the housing of the single battery cell to detect the resistance signal generated by the strain inside the single battery cell. The external sensor 10241, i.e., the thin film strain gauge, can detect the resistance signal generated by the housing strain caused by stress inside the single battery cell.

In one embodiment of the disclosure, as shown in FIG. 2, the stress acquisition circuit 1024 further includes an amplifying circuit 10243, a signal acquisition circuit 10246, a digital logic circuit 10247, and a communication interface 10248.

The bridge circuit 10242 is connected to the amplifying circuit 10243 for amplifying the strain voltage signal.

The signal acquisition circuit 10246 is connected to the amplifying circuit 10243, and the signal acquisition circuit 10246 is configured to acquire the strain voltage signal outputted by the amplifying circuit 10243 and convert the strain voltage signal into a digital signal form.

Note that, the amplifying circuit 10243 outputs the strain voltage signal in an analog signal form and the signal acquisition circuit 10246 acquires the strain voltage signal and converts the strain voltage signal into a digital signal form.

The digital logic circuit 10247 is connected to the signal acquisition circuit 10246 and the digital logic circuit 10247 is configured to optimize and adjust the strain voltage signal in the digital signal form.

In embodiments of the present disclosure, the digital logic circuit 10247 may optimize and adjust the strain voltage signal in the digital signal form, such as anti-aliasing, SNR adjustment, etc., such that the strain voltage signal in the digital signal form is outputted more stably.

The communication interface 10248 is connected to the digital logic circuit 10247, and the communication interface 10248 is configured to transmit the strain voltage signal in the digital signal form to the processing circuit 101.

In an embodiment of the present disclosure, the stress acquisition circuit 1024 further includes an acquisition wake-up circuit 10244 and a wake-up reference circuit 10245.

The signal acquisition circuit 10246 is further configured to acquire the strain voltage signal outputted by the amplifying circuit 10243 and convert the strain voltage signal into the digital signal form after being woken up.

The wake-up reference circuit 10245 is connected to the digital logic circuit 10247. The wake-up reference circuit 10245 is configured to store a stress threshold in an analog signal form and update the stress threshold in the analog signal form according to the strain voltage signal in the digital signal form sent by the digital logic circuit 10247.

The acquisition wake-up circuit 10244 is connected to the amplifying circuit 10243, the wake-up reference circuit 10245, and the signal acquisition circuit 10246, respectively, and is configured to compare the amplified strain voltage signal with the stress threshold in the analog signal form. When the amplified strain voltage signal exceeds the stress threshold in the analog signal form, the acquisition wake-up circuit 10244 awakens the signal acquisition circuit 10246 and disconnects the signal acquisition circuit 10246 after the acquisition is completed.

In an embodiment of the present disclosure, the stress threshold value refers to a stress value that protects the single battery cell from damage. In an initial state, the processing circuit 101 sets the stress threshold according to the state of charge of the single battery cell, i.e. the processing circuit 101 sets the stress threshold in the digital signal form via the communication interface 10248, the digital logic circuit 10247 into the wake-up reference circuit 10245, and the wake-up reference circuit 10245 converts the stress threshold in the digital signal form into the stress threshold in the analog signal form and stores it.

The acquisition wake-up circuit 10244 is connected to the amplifying circuit 10243, the wake-up reference circuit 10245, and the signal acquisition circuit 10246, respectively, and is configured to compare amplified strain voltage signal to the stress threshold in the analog signal form. When amplified strain voltage signal exceeds the stress threshold, the acquisition wake-up circuit 10244 awakens the signal acquisition circuit 10246.

When the amplified strain voltage signal is greater than the stress threshold in the analog signal form, it indicates that the stress exceeds the stress safety threshold of the single battery cell. The acquisition wake-up circuit 10244 may turn on the signal acquisition circuit 10246. At this point, the signal acquisition circuit 10246 may acquire the amplified strain voltage signal and send it to the digital logic circuit 10247. The digital logic circuit 10247 optimizes and adjusts the strain voltage signal in the digital signal form. On the one hand, the optimized and adjusted strain voltage signal is sent to the wake-up reference circuit 10245 to update the stress threshold in the analog signal form, and on the other hand, the strain voltage value (i.e. the pressure inside the single battery cell) is sent to the processing circuit 101 via the communication interface 10248.

In an embodiment of the disclosure, the processing circuit 101 is further configured to set the stress threshold initially stored in the wake-up reference circuit 10245.

In an embodiment of the present disclosure, in the initial state of the battery cell, the processing circuit 101 may send the initial stress threshold to the wake-up reference circuit 10245 via the communication interface 10248 and the digital logic circuit 10247, and then the wake-up reference circuit 10245 converts the stress threshold into the stress threshold in the analog signal form.

Due to the different stresses that the single battery cell can withstand at different times of use, the corresponding initial stress thresholds are also different. The processing circuit 101 may set the corresponding stress threshold according to the state of charge of the single battery cell. When the stress inside the single battery cell is within a safety threshold, the acquisition wake-up circuit 10244 is in the sleep state. When the stress inside the single battery cell exceeds the safety threshold, the acquisition wake-up circuit 10244 is only released from the sleep state. Therefore, the stress parameters of the single battery cell will only be acquired when the stress safety threshold is exceeded, so that the stress acquisition circuit 1024 does not need to acquire the stress parameters of the single battery cell throughout the entire process, and the operating power consumption of the entire chip is reduced.

In an embodiment of the present disclosure, as shown in FIG. 1, the battery cell management chip 10 communicates with the upper level control circuit 20 via a wireless transmission circuit 104. The battery cell management chip 10 further includes the wireless transmission circuit 104, and the wireless transmission circuit 104 is connected to the processing circuit 101. The upper level control circuit 20 can be a master control circuit in a battery management system BMS. A BMS can be connected to a plurality of battery cell management chips 10, the wireless transmission circuit 104 may send the information representing the battery cell itself, such as the operating parameters and the SOC of the single battery cell, to the upper level control circuit 20, so that a BMS may monitor the operating states of a plurality of single battery cells. Compared with the existing technology of monitoring the operation states of battery modules, it can more accurately identify the reasons for abnormal operating states of batteries and improve the safety of battery systems.

Note that, the wireless transmission circuit 104 may perform bi-directional signal transmission, and the upper level control circuit 20 may also send control signals to the processing circuit 101 via the wireless transmission circuit 104 to control the single battery cell. In an embodiment, when the upper level control circuit 20 needs to adjust the state of a battery cell from an operating state to a sleep state, a control signal can be sent to the processing circuit 101 via the wireless transmission circuit 104. The processing circuit 101 controls the battery cell to enter the sleep state after receiving the control signal. The wireless control saves time and reduces power compared to wired control.

In the present disclosure data is transmitted by means of wireless communication, first, isolation devices and Electromagnetic Interference (EMI)/Electromagnetic compatibility (EMC) protection devices required for noise-coupled interference in the wired communication harnesses are reduced, the complexity of the battery sampling plate is reduced, and the application is more flexible. Secondly, compared to twisted pair daisy chain serial wired communication, wireless communication makes information exchange more flexible and convenient, enables natural time synchronization measurement and supports more synchronous sensing functions. Furthermore, it can avoid the problem of multiple battery information loss in serial communication due to wiring harness reasons, thereby improving the safety of the entire vehicle. Finally, in terms of structure, the absence of complex wiring harnesses and connectors can improve design flexibility and make maintenance simpler and more convenient.

In an embodiment of the disclosure, the wireless transmission circuit 104 is further configured to switch different operating states according to signals sent by the processing circuit 101. The different operating states include a sleep state, an un-sleep state, a synchronous transceiving mode and a low power consumption mode.

In an embodiment of the present disclosure, when the single battery cell is switched to the sleep state, the control circuit 1013 may send a control signal to the wireless transmission circuit 104 to also enter the sleep state. It is also possible to switch to other operating states such as an un-sleep state, a synchronous transceiving mode, a (Tx-only) only send no receive operating mode, and a (Rx-only) only receive no send operating mode.

Note that, the wireless transmission circuit 104 in the present disclosure has the characteristics of low power consumption, short distance, and high robustness, and operates in the ISM radio frequency band. In addition, the transmit power can be selected within different power levels according to the transmit distance, and the operating power consumption of the entire chip is reduced.

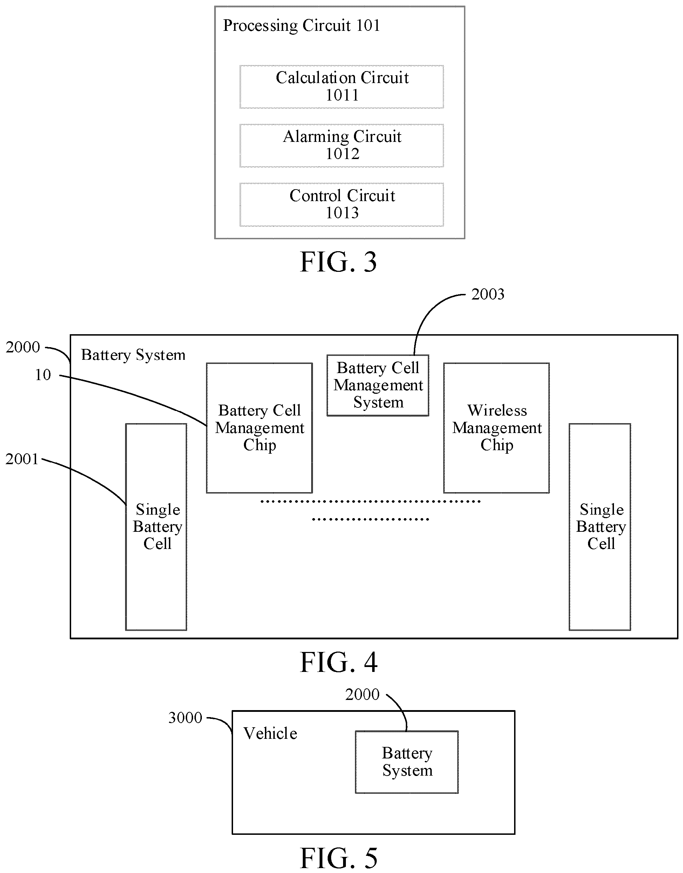

FIG. 3 shows a block diagram of a processing circuit 101 according to an embodiment of the present disclosure. In an embodiment of the present disclosure, the processing circuit 101 may include a calculation circuit 1011. The calculation circuit 1011 is configured to calculate the state of charge SOC of the single battery cell according to the parameter value of the operating parameter, determine the new dynamic protection threshold according to the SOC, and store the new dynamic protection threshold in the storage circuit 105.

In an embodiment of the present disclosure, the operating parameters may be at least one of a voltage, a temperature, a current, and a stress of the single battery cell. The calculation circuit 1011 may calculate the SOC of the single battery cell according to at least one of a voltage value, a temperature value, a current value, and a stress value of the single battery cell, thereby improving the accuracy of battery state estimation. The calculation circuit 1011 stores a preset mapping relationship, that is, different SOCs correspond to different dynamic protection thresholds. The preset mapping relationship may be stored in the form of a data table. The calculation circuit 1011 may determine a new dynamic protection threshold by means of a look-up data table, for example, when the calculated SOC is 60%, the dynamic protection threshold of the single battery cell corresponding to 60% can be queried through the data table. Based on this, the calculation circuit 1011 can determine a new dynamic protection threshold (e.g., a dynamic voltage protection threshold, a dynamic temperature protection threshold, etc.) of the single battery cell according to the different state of charge of the single battery cell, store the dynamic protection threshold in the storage circuit 105 and cover the previous dynamic protection threshold with the dynamic protection threshold, thereby updating the dynamic protection threshold in the storage circuit 105.

In an embodiment of the present disclosure, the processing circuit 101 further includes an alarming circuit 1012. The alarming circuit 1012 is configured to compare the parameter value of the operating parameter with the dynamic protection threshold for the operating parameter stored in the storage circuit 105 and send an alarming message to the upper level control circuit 20 according to the comparison result.

In an embodiment of the present disclosure, the alarming circuit 1012 may compare the parameter value of the operating parameter acquired by the acquisition circuit 102 with the dynamic protection threshold stored in the storage circuit 105. For example, when the operating parameter includes a voltage parameter and when the voltage value is higher than the dynamic voltage protection threshold of the previous time in the storage unit, it indicates that the voltage of the current single battery cell is overvoltage, and the alarming circuit 1012 sends an alarm to the control circuit 1013 and/or the upper level control circuit 20 (i.e., the master control circuit). Therefore, when the single battery cell operates abnormally, it can be processed simultaneously by both the control circuit 1013 and the upper level control circuit 20 such that either of the control circuit 1013 and the upper level control circuit 20 fails, the single battery cell can be processed to improve the efficiency of the fault processing.

In an embodiment of the present disclosure, the alarming circuit 1012 may also determine whether the voltage of the single battery cell is outside the average voltage interval according to the average voltage interval value of the single battery cell sent by the upper level control circuit 20 and received by the control circuit 1013. It will be noted that under normal circumstances, the average voltage interval of the single battery cell is [1.8 v-5.0 v].

In an embodiment of the present disclosure, the processing circuit 101 further includes the control circuit 1013. The control circuit 1013 is configured to control the dynamic protection circuit 106 to adjust the operating state of the single battery cell according to the alarming message.

The control circuit 1013 may receive and process the alarming message sent by the alarming circuit 1012, and the process controls the dynamic protection circuit 106 to switch the state of the single battery cell to protect the single battery cell. For example, when the voltage of the single battery cell is overvoltage, the control circuit 1013 controls the single battery cell to stop discharging or charging to protect the voltage of the single battery cell.

In an embodiment of the present disclosure, the operating parameters further include at least one of a voltage, a current, and a temperature. As shown in FIG. 1, the acquisition circuit 102 includes at least one of a voltage acquisition circuit 1021, a current acquisition circuit 1022, and a temperature acquisition circuit 1023. The specific combination method is not limited here.

The voltage acquisition circuit 1021 is configured to acquire the voltage value of the single battery cell. The current acquisition circuit 1022 is configured to acquire the current value of the single battery cell. The temperature acquisition circuit 1023 is configured to acquire the temperature value of the single battery cell. In an embodiment of the present disclosure, the voltage acquisition circuit 1021 can acquire the potential difference between the positive and negative electrodes of the single battery cell to obtain the voltage value. The current acquisition circuit 1022 acquires the current value of the single battery cell via the current sensor.

Since heat is released inside the battery cell during the charging and discharging process and regular discharging process, temperature of the battery cell varies at different times, and temperature acquisition circuit 1023 acquires the temperature value of the battery cell via a thermistor.

As shown in FIG. 1, in an embodiment of the present disclosure, the acquisition circuit 102 further includes a multiplexer 1025 (MUX), one end of the MUX 1025 is connected to the voltage acquisition circuit 1021, the current acquisition circuit 1022, the temperature acquisition circuit 1023, and the stress acquisition circuit 1024, respectively, and the other end of the MUX 1025 is connected to processing circuit 101.

The processing circuit 101 is further configured to send a selection instruction to the MUX 1025. The MUX 1025 is configured to select any one of the voltage acquisition circuit 1021, the current acquisition circuit 1022, the temperature acquisition circuit 1023 and the stress acquisition circuit 1024 according to the selection instruction to send the parameter value of the operating parameter of the single battery cell to the processing circuit 101.

The MUX 1025 refers to a circuit that can select any one of channels as needed during the process of multi-channel data transmission, also known as a multiplexer or a multiplex switch. In an embodiment of the present disclosure, the MUX 1025 is a multiplexed NMOS or PMOS switch.

The selection instruction refers to instruction sent by the processing circuit 101 to obtain any one of operating parameters of the single battery cell, for example, the MUX 1025 receives the selection instruction to obtain the temperature value of the single battery cell and opens loop of the temperature acquisition circuit 1023 so that the temperature acquisition circuit 1023 acquires the temperature of the single battery cell and sends it to the processing circuit 101.

As shown in FIG. 1, in an embodiment of the disclosure, the dynamic protection circuit 106 includes an over-voltage protection circuit 1062.

The over-voltage protection circuit 1062 is configured to control the single battery cell to stop charging or discharging when the voltage value of the single battery cell exceeds a dynamic voltage protection threshold.

The dynamic voltage protection threshold refers to the maximum operating voltage of the single battery cell. In one embodiment, assuming the dynamic voltage protection threshold of 4.3 v for the single battery cell, when the voltage of the single battery cell exceeds 4.3 v, the single battery cell is overvoltage. At this point, on the one hand, the alarming circuit 1012 sends an alarm to the upper level control circuit 20, and on the other hand, the over-voltage protection circuit 1062 controls the single battery cell to stop discharging or charging.

In an embodiment of the disclosure, the dynamic protection circuit 106 further includes at least one of an equalization circuit 1061, an over-temperature protection circuit 1063, an over-current protection circuit 1064, and a state protection circuit 1065.

The equalization circuit 1061 is configured to initiate a voltage equalization strategy when the voltage value of the single battery cell lies outside a preset average voltage value interval such that the voltage of the single battery cell lies within the preset average voltage value interval.

The preset average voltage value interval refers to the normal interval of the average voltage of each single battery cell. When the voltage of a single battery cell lies outside the average voltage value interval, it indicates that the current operating state of the single battery cell is abnormal. At this point, on the one hand, the alarming circuit 1012 sends an alarm to the upper level control circuit 20, and on the other hand, the equalization circuit 1061 initiates a voltage equalization strategy to maintain the single battery cell voltages consistent, maximize the discharge capacity of the battery and extend the lifespan of the battery.

The over-temperature protection circuit 1063 is configured to control the single battery cell to enter a sleep state when the temperature value of the single battery cell exceeds a dynamic temperature protection threshold.

The dynamic temperature protection threshold refers to the maximum temperature that a single battery cell can withstand. Normally, the temperature of the single battery cell should not exceed 125 degrees Celsius, that is, the dynamic temperature protection threshold is 125 degrees Celsius. When the acquired temperature of the single battery cell is above 125 degrees Celsius, it indicates that the single battery cell is overheated. At this point, on the one hand, the alarming circuit 1012 sends an alarm to the upper level control circuit 20 and on the other hand, the over-temperature protection circuit 1063 activates the battery thermal management system to reduce the battery temperature. Alternatively, when the acquired temperature of the single battery cell exceeds the maximum allowable temperature, the circuit is automatically cut off and the single battery cell is controlled to enter a sleep state.

The over-current protection circuit 1064 is configured to control the single battery cell to stop charging or discharging when the current value of the single battery cell exceeds a dynamic current protection threshold.

The dynamic current protection threshold refers to the maximum current that a single battery cell can withstand. Normally, the current of the single battery cell does not exceed 5A, i.e. the dynamic current protection threshold is 5A in the initial state, and is updated as the usage state of the single battery cell. In an embodiment, in the initial state, when the acquired current of the single battery cell is higher than 5A, it indicates that the single battery cell is overcurrent. At this time, on the one hand, the alarming circuit 1012 sends an alarm to the upper level control circuit 20 and on the other hand, the over-current protection circuit 1064 controls the single battery cell to stop charging or discharging.

In an embodiment of the present disclosure, the parameter value of the operating parameter acquired by any acquisition unit in the acquisition circuit 102 can be obtained by the multiplexer MUX according to the instruction of the control circuit 1013 in the processing circuit 101, and it is possible to obtain the parameter values according to the requirement of the control circuit 101. In addition, the state of a single battery cell is monitored by a battery cell management chip, and the risk of losing state information of multiple battery strings due to the failure of a single battery cell is reduced. Furthermore, the present disclosure uses wireless transmission techniques, it is possible to enable the upper level control circuit 20 to obtain state information of the single battery cell at any time, thereby enabling the battery cell management system to monitor and manage each battery cell in real time, and the loss of information of multiple battery strings in serial communication due to complex wiring harnesses can be avoided, thus the low-power operation can be achieved. Moreover, by using the processing circuit 101 to estimate the state parameters of the single battery cell in real time and determine the dynamic protection threshold of the single battery cell according to the usage states, real-time acquisition of the dynamic protection threshold of the single battery cell can be achieved. Finally, the dynamic protection circuit 106 enables the single battery cell to operate within the dynamic protection threshold at all times, thereby achieving efficient usage and protection of the battery, and improving the useful life of the battery.

An embodiment of the second aspect of the present disclosure also provides a battery system. FIG. 4 illustrates a battery system 2000 according to an embodiment of the present disclosure, which is an acquisition-control-transmission integrated battery system 2000 with Analog Front End (AFE) chips deployed independently on each single battery cell 2001. The battery system 2000 includes a plurality of battery cells 2001, a plurality of battery cell management chips 10 connected to the plurality of battery cells 2001 one to one, and a battery cell management system (EMS) 2003. The plurality of battery cells 2001 can form a battery module, a plurality of battery modules can form a battery, each battery cell 2001 is monitored and managed by a single battery cell management chip 10, and the upper level control circuit in the EMS and the control circuit in the battery cell management chip 10 communicate wirelessly through a wireless transmission circuit, thereby reducing the complexity of conventional wire harness connections and improving communication convenience and making maintenance of the battery system 2000 more convenient.

An embodiment of the third aspect of the present disclosure also provides a vehicle. FIG. 5 illustrates a vehicle 3000 of an embodiment of the present disclosure, the vehicle 3000 includes a battery system 2000 according to any of the embodiments of the second aspect of the present disclosure described above, and the battery system 2000 supplies power to the vehicle 3000.

Various embodiments in this specification are described in a progressive manner, with each embodiment emphasizing its differences from other embodiments. The same and similar parts between the various embodiments can be referred to each other.

Although the preferred embodiments of the present disclosure have been described, further changes and modifications may be made thereto by a person of ordinary skill in the art once the basic inventive concept is known. Therefore, the appended claims are intended to be construed to include the preferred embodiments and all changes and modifications that fall within the scope of the embodiments of the present disclosure.

Finally, it should be noted that relational terms such as first and second, and the like are only used to distinguish one entity or operation from another, without necessarily requiring or implying any actual relationship or order between such entities or operations. The terms "include", "comprise," or any other variation thereof, are intended to cover a non-exclusive inclusion, so that a process, method, article, or terminal device that includes a list of elements does not include only those elements, also includes other elements not explicitly listed, or also includes elements inherent to such process, method, article, or terminal device. Without further limitations, an element defined by the phrase "includes a...." does not exclude the existence of additional identical elements in the process, method, article, or terminal device that includes the element.

A detailed description of the wireless management chip, battery system, and vehicle provided by the present disclosure has been presented, and specific examples have been applied to explain the principles and implementations of the present disclosure, and the description of the above embodiments has been presented only to assist in understanding the methods of the present disclosure and the core concepts thereof. Meanwhile, for a person of ordinary skill in the art, there may be changes in the specific embodiments and application scope depending on the spirit of the present disclosure, in summary, the above description should not be understood as limitation to the present disclosure.

## Claims

1. A battery cell management chip (10), wherein the battery cell management chip (10) is connected to a single battery cell (2001), the battery cell management chip (10) comprising:
a processing circuit (101);
an acquisition circuit (102), connected to the processing circuit (101), the acquisition circuit (102) being configured to acquire a parameter value of an operating parameter of the single battery cell (2001) and transmit the parameter value to the processing circuit (101);
a power supply (103), connected to the processing circuit (101), the power supply (103) being configured to supply power to the processing circuit (101);
a dynamic protection circuit (106), connected to the processing circuit (101); and
a storage circuit (105), connected to the processing circuit (101), the storage circuit (105) being configured to store a dynamic protection threshold for the operating parameter;
wherein the processing circuit (101) is configured to compare the parameter value of the operating parameter with the dynamic protection threshold and control the dynamic protection circuit (106) to adjust the operating state of the single battery cell (2001) according to a comparison result, and determine a state of charge , SOC, of the single battery cell (2001) according to the parameter value of the operating parameter, and update the dynamic protection threshold of the single battery cell (2001) stored in the storage circuit (105) according to the SOC; and
the dynamic protection circuit (106) being configured to adjust the operating state of the single battery cell (2001) according to the dynamic protection threshold.

2. The battery cell management chip (10) according to claim 1, wherein the operating parameter comprises stress, and the acquisition circuit (102) comprises a stress acquisition circuit (1024) configured to acquire a stress value of the single battery cell (2001).

3. The battery cell management chip (10) according to claim 2, wherein the dynamic protection circuit (106) comprises a state protection circuit (1065) configured to control the single battery cell (2001) to stop charging or discharging when the stress value of the single battery cell (2001) is greater than a dynamic stress protection threshold.

4. The battery cell management chip (30) according to claim 2 or claim 3, wherein the stress acquisition circuit (1024) comprises a bridge circuit (10242) connected to the single battery cell (2001) via an external sensor (10241), the bridge circuit (10242) is configured to determine a strain voltage signal according to strain information inside the single battery cell (2001) detected by the external sensor (10241).

5. The battery cell management chip (10) according to claim 4, wherein the external sensor (10241) is a stress sensor, and the stress sensor is a thin film strain gauge.

6. The battery cell management chip (10) according to claim 5, wherein the thin film strain gauge is provided on a housing of the single battery cell (2001).

7. The battery cell management chip (10) according to any one of claims 4 to 6, wherein the stress acquisition circuit (1024) further comprises:
an amplifying circuit (10243) connected to the bridge circuit (10242), the amplifying circuit (10243) being configured to amplify the strain voltage signal;
a signal acquisition circuit (10246) connected to the amplifying circuit (10243), the signal acquisition circuit (10246) being configured to acquire the strain voltage signal outputted by the amplifying circuit (10243) and convert the strain voltage signal into a digital signal form;
a digital logic circuit (10247), connected to the signal acquisition circuit (10246), the digital logic circuit (10247) being configured to optimize and adjust the strain voltage signal in the digital signal form; and
a communication interface (10248), connected to the digital logic circuit (10247), the communication interface (10248) being configured to transmit the strain voltage signal in the digital signal form to the processing circuit (101).

8. The battery cell management chip (10) according to claim 7, wherein the signal acquisition circuit (10246) is further configured to acquire the strain voltage signal outputted by the amplifying circuit (10243) and convert the strain voltage signal into the digital signal form after being woken up,
the stress acquisition circuit (1024) further comprises:
a wake-up reference circuit (10245), connected to the digital logic circuit (10247), the wake-up reference circuit (10245) being configured to store a stress threshold in an analog signal form and update the stress threshold in the analog signal form according to the strain voltage signal in the digital signal form sent by the digital logic circuit (10247); and
an acquisition wake-up circuit (10244) connected to each of the amplifying circuit (10243), the wake-up reference circuit (10245), and the signal acquisition circuit (10246), the acquisition wake-up circuit (10244) being configured to compare the amplified strain voltage signal with the stress threshold in the analog signal form, awaken the signal acquisition circuit (10246) when the amplified strain voltage signal exceeds the stress threshold in the analog signal form, and disconnect the signal acquisition circuit (10246) after the acquisition is completed.

9. The battery cell management chip (10) according to claim 8, wherein the processing circuit (101) is further configured to set the stress threshold initially stored in the wake-up reference circuit (10245).

10. The battery cell management chip (10) according to any one of claims 1 to 9, wherein the battery cell management chip (10) further comprises a wireless transmission circuit (104) connected to the processing circuit (101), the wireless transmission circuit (104) is configured to perform wireless data transmission with an upper level control circuit (20), and the battery cell management chip (10) communicates with the upper level control circuit (20) via the wireless transmission circuit (104).

11. The battery cell management chip (10) according to claim 10, wherein the wireless transmission circuit (104) is further configured to switch different operating states according to signals sent by the processing circuit (101), and the different operating states comprise a sleep state, an unsleep state, a synchronous transceiving mode and a low power consumption mode.

12. The battery cell management chip (10) according to any one of claims 1 to 11, wherein the processing circuit (101) comprises a calculation circuit (1011), the calculation circuit (1011) configured to calculate the state of charge SOC of the single battery cell (2001) according to the parameter value of the operating parameter, determine the new dynamic protection threshold according to the SOC, and store the new dynamic protection threshold in the storage circuit (105).

13. The battery cell management chip (10) according to claim 12, wherein the processing circuit (101) further comprises an alarming circuit (1012) configured to compare the parameter value of the operating parameter with the dynamic protection threshold for the operating parameter stored in the storage circuit (105) and send an alarming message to the upper level control circuit (20) according to the comparison result.

14. The battery cell management chip (10) according to claim 13, wherein the processing circuit (101) further comprises a control circuit (1013) configured to control the dynamic protection circuit (106) to adjust the operating states of the single battery cell (2001) according to the alarming message.

15. The battery cell management chip (10) according to claim 2, wherein the operating parameters further comprise at least one of a voltage, a current, a temperature, the acquisition circuit (102) comprises at least one of a voltage acquisition circuit (1021), a current acquisition circuit (1022) and a temperature acquisition circuit (1023),
the voltage acquisition circuit (1021) is configured to acquire a voltage value of the single battery cell (2001), the current acquisition circuit (1022) is configured to acquire a current value of the single battery cell (2001) and the temperature acquisition circuit (1023) is configured to acquire a temperature value of the single battery cell (2001).

16. The battery cell management chip (10) according to claim 15, wherein the acquisition circuit (102) comprises a multiplexer (1025), one end of the multiplexer (1025) is connected to each of the voltage acquisition circuit (1021), the current acquisition circuit (1022), the temperature acquisition circuit (1023) and the stress acquisition circuit (1024), and the other end of the multiplexer (1025) is connected to the processing circuit (101),
the processing circuit (101) is further configured to send a selection instruction to the multiplexer (1025),
the multiplexer (1025) is configured to select any one of the voltage acquisition circuit (1021), the current acquisition circuit (1022), the temperature acquisition circuit (1023) and the stress acquisition circuit (1024) according to the selection instruction to transmit the parameter value of the operating parameter of the single battery cell (2001) to the processing circuit (101).

17. The battery cell management chip (10) according to claim 15 or claim 16, wherein the dynamic protection circuit (106) comprises an over-voltage protection circuit (1062) configured to control the single battery cell (2001) to stop charging or discharging when the voltage value of the single battery cell (2001) exceeds a dynamic voltage protection threshold.

18. The battery cell management chip (10) according to any one of claims 15 to 17, wherein the dynamic protection circuit (106) further comprises at least one of an equalization circuit (1061), an over-temperature protection circuit (1063), and an over-current protection circuit (1064),
and the equalization circuit (1061) is configured to initiate a voltage equalization strategy when the voltage value of the single battery cell (2001) lies outside a preset average voltage value interval such that the voltage value of the single battery cell (2001) lies within the preset average voltage value interval;
the over-temperature protection circuit (1063) is configured to control the single battery cell (2001) to enter a sleep state when the temperature value of the single battery cell (2001) exceeds a dynamic temperature protection threshold;
the over-current protection circuit (1064) is configured to control the single battery cell (2001) to stop charging or discharging when the current value of the single battery cell (2001) exceeds a dynamic current protection threshold.

19. A battery system (2000) comprising:
a plurality of single battery cells (2001);
a battery cell management system (2003); and
the battery cell management chip (10) according to any one of claims 1 to 18.

20. A vehicle (3000) comprising the battery system (2000) according to claim 19.
